# EUROPEAN PATENT APPLICATION

(11) **EP 4 119 964 A1**
(43) Date of publication of application: **18.01.2023**
(21) Application number: 22184273.5
(22) Date of filing: 12.07.2022
(51) Int. Cl.: G01R 31/385, G01R 31/387

(54) **DIAGNOSTIC METHOD AND APPARATUS FOR BATTERIES**

(30) Priority: 15.07.2021 IT 202100018674
(71) Applicant: VI.SA. S.r.l., 80044 Ottaviano (NA) (IT)
(72) Inventor: SALVATI, Fabio, 80044 Ottaviano (NA) (IT)
(74) Representative: Cercenà, Alice

(57) **Abstract**

The present invention relates to a diagnostic method for traction batteries of the lithium type (100) for vehicles for mainly personal use. In particular, the method essentially comprising the following steps:
a) connecting at least one battery (100) equipped with a battery charger (200) associated with it, to an apparatus (1) for battery diagnostics via input/output connections, said apparatus (1) including at least detection means (30) adapted to detect characteristic parameters of said battery (100), a command and control unit (40) comprising at least a temporary storage unit (50) configured to store the data associated with said battery (100) and a processing unit (41) for controlling the operation of at least one electrical load dissipation device (20) and of said battery charger (200) connectable to an electrical power source, said electrical load dissipation device (20) and said battery charger (200) being selectively couplable to said battery (100);
b) acquiring a series of reference characteristic parameters (SETn, SETt) of the battery (100) and storing them in said temporary storage unit (50);
c) coupling said electrical load dissipation device (20) to said battery (100) and implementing a discharging cycle of said at least a battery (100);
d) de-coupling said electrical load dissipation device (20) from said battery (100), coupling said battery charger (200) to said battery (100) and implementing a charging cycle of said battery (100);
e) detecting, during said steps c) and d), a series of current characteristic parameters (SETr) of said battery (100) through said detection means (30) and storing them in the temporary storage unit (50);
f) comparing said series of reference characteristic parameters (SETn, SETt) of the battery (100) with said series of current characteristic parameters (SETr) of the battery (100) to evaluate the compliance of the battery (100).
Furthermore, the present invention relates to an apparatus (1) adapted to implement said diagnostic method for batteries.

## Description

### TECHNICAL FIELD OF THE INVENTION

The present invention relates to a diagnostic method for batteries and the relative apparatus. In particular, the diagnostic method and apparatus are adapted to test rechargeable traction batteries of the lithium type which can be used on transportation vehicles for mainly personal use, such as for example bicycles, mopeds, scooters and hoverboards.

### BACKGROUND OF THE INVENTION

Charge accumulators, commonly referred to as rechargeable batteries, are devices having the purpose of converting electrical energy into chemical energy, and vice versa, through reversible redox reactions.

Basically, irrespective of the type of substances used, inside such devices there is a first substance which undergoes an oxidation process (anode - positive electrode) losing electrons while a second substance, separated from the first by a connection electrolyte, undergoes a redox process, gaining electrons (cathode- negative electrode). The charge flow produced between the anode and cathode is intercepted and used to power-supply electric equipment.

The secondary batteries are rechargeable: applying an appropriate potential difference to the electrodes allows to return the cell to the initial condition, storing new energy in chemical form.

The basic unit of a battery is the cell, and the set of several cells arranged in series, parallel or in hybrid configurations is instead referred to as battery pack, or simply battery.

The battery market is expanding significantly and the rechargeable industry represents almost 80% of the entire business. The main applications are on personal electronic devices such as mobile phones, computers, etc, and on traction vehicles.

Currently, rechargeable batteries that offer the best performance are those based on lithium, lithium-ion, lithium-polymer, lithium-iron-phosphate technologies.

The fundamental characteristic parameters which describe a cell, obviously besides chemical which identifies the type of battery taken into account, are nominal voltage and nominal capacity.

As a matter of fact, each type of cell has a characteristic voltage thereof, linked to the active substances that it is made up of. Nominal voltage is a fixed value, indicated by the manufacturer. The actual voltage is instead a function variable with time which depends on various parameters such as for example internal impedance, operating temperature, state of charge, age of the cell, charge or discharge current.

Expressed in Ah, the nominal capacity of a cell is instead the amount of current supplied by the battery within a determined period of time.

Unlike other technologies, in all operating conditions lithium batteries require a verification of the condition of the cells. As a matter of fact, it should be borne in mind that the cells that form a battery may not be identical for example due to slight construction differences or ageing effects; this results in the fact that the actual voltage and capacity vary from one cell to another, although nominally identical.

Therefore, a battery with unbalanced cells connected in series and subjected to the same discharge current has to interrupt the operation thereof when the cell with lower charge reaches full charge. Such voltage is called cut-off voltage and it corresponds to the voltage at which a battery is considered discharged, beyond which further discharge could permanently damage the battery. Similarly, the battery charge step must be interrupted when one of the cells thereof is the first to reach the maximum voltage thereof, so as avoid overcharge.

Therefore, such batteries are provided with a BMS (Battery Management System), that is an electronic control system integrated in the battery pack right from the manufacture thereof, which continuously monitors the condition thereof and actively take action balancing the cells and activating protections should need arise.

Battery sellers often buy the latter from manufacturers often located out of Europe. Therefore, they reach the warehouses of the sellers after transportation by air, during which they may be subjected to significant temperature, pressure and humidity changes and be subjected to vibrations and mechanical stresses.

Furthermore, the batteries may be subjected to long storage (and therefore non-use) periods in the warehouses. All these conditions could cause the deterioration of the battery performance.

Therefore, there arises the problem of verifying and possibly certifying, at the time of sale, whether the battery performance essentially complies with the nominal ones stated by the manufacturer or whether they have deteriorated, possibly evaluating and quantifying the damage thereon.

Furthermore, it is commonly observed that the performance of the rechargeable batteries changes with time, progressively losing performance with time and as they are used. Battery ageing processes are irreversible changes in the electrolyte, anode, cathode characteristics and in the structure of the components used in the battery.

Battery performance loss essentially relates to two aspects: a progressive loss of capacity, which results in decrease in the duration of the charge, and an increase in internal resistance, which leads to a decrease in the power supplied.

The degradation phenomena of the battery depend on many factors, such as the use conditions, frequency and intensity of charge and discharge processes, the non-use times, operating temperature.

Therefore, manufacturers often provide reference models for "standard" deterioration of the batteries thereof. However, it is difficult to predict the life cycle of cells given that the ageing mechanisms are the result of various processes related to each other, which occur even with different time scales, which relate not only to electrodes and active materials but all components of the battery.

In the field of traction batteries for two, three or four-wheeled transportation vehicles essentially for personal use, such as for example bicycles, mopeds, hoverboards or scooters, the battery represents the most expensive single component of the vehicle, and it is therefore appropriate that the battery, which is supplied alongside the vehicle together with compatible battery chargers, be in optimal conditions.

As a result, in order to satisfy and retain customers, there arises the need to verify and possibly certify whether the battery actually complies with the characteristics stated by the manufacturer at the time of sale of the vehicle.

Furthermore, after the vehicle has been sold and at pre-established intervals, the conditions of the battery should be evaluated, providing the customer with quality and quantity indications relating to the residual duration of the battery.

### SUMMARY OF THE INVENTION

The main task of the subject matter of the present invention is to provide a diagnostic method for batteries, particularly but not exclusively traction batteries for vehicles essentially for personal use, which allows to verify and possibly certify whether the battery actually complies with the characteristics stated by the manufacturer at the time of sale of the vehicle, as well as evaluate, after the vehicle has been sold and at pre-established time intervals, the condition of the battery, providing quality and quantity indications relating to the residual duration of the battery.

In the context of the present task, an object of the present invention is to provide a method which allows to verify the conditions of the battery together with those relating to the relative battery charger, provided at the time of purchase.

Another object of the present invention is to provide a diagnostic apparatus which allows to carry out the diagnostic method for batteries according to the present invention.

The task, objects and advantages outlined above, as well as others which will be more apparent in the description below, are attained by a method as defined in claim 1.

### BRIEF DESCRIPTION OF THE FIGURES

Advantages and characteristics of a diagnostic method and apparatus according to the present invention will be better illustrated in the description of a particular, but not exclusive embodiment shown purely by way of example in the attached drawings, wherein:
- figure 1 shows, with a schematic view, a diagnostic apparatus of a battery according to the present invention; and
- figure 2 shows, with perspective view, a structure for supporting the apparatus according to figure 1.

### DETAILED DESCRIPTION OF THE INVENTION

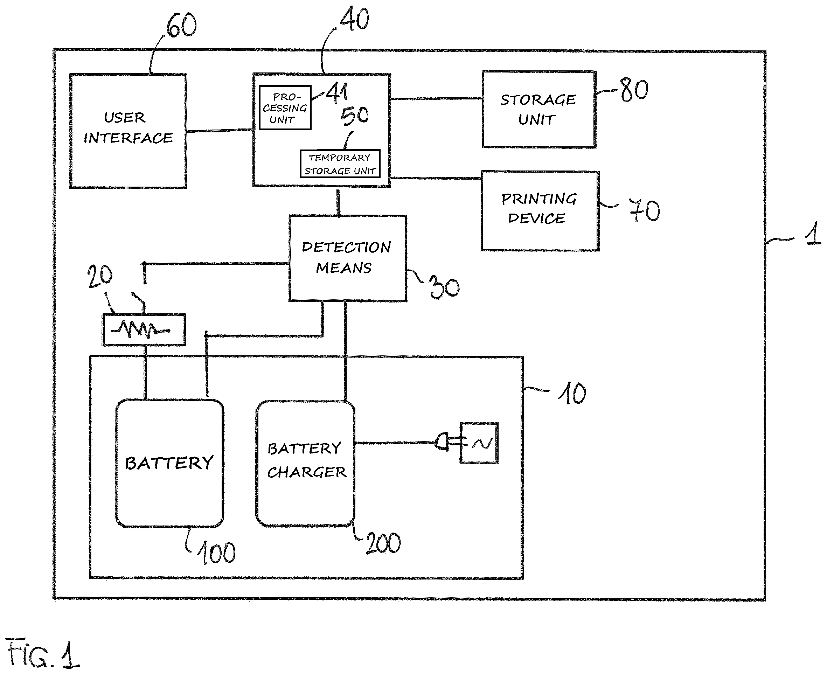

With reference to figure 1, schematically shown is a diagnostic apparatus 1 adapted to carry out diagnostic method for batteries according to the present invention.

In particular, preferably, the present invention relates to an apparatus 1 and a diagnostic method for at least a traction battery 100 of the lithium type for two, three or four-wheeled transportation vehicles for mainly personal use such as for example bicycles, mopeds, scooters or hoverboards.

The battery 100 is generally sold to the customer who purchases the vehicle together with a compatible battery charger 200. At the time of sale, the battery 100 is therefore advantageously tested using a diagnostic method according to the present invention together with the battery charger 200 associated therewith, so as to certify the compliance of the battery 100 with respect to the nominal settings provided by the manufacturer, as well as the correct functions of the battery charger 200.

After a determined time interval from the time of sale, the battery 100 may be subjected to a new diagnostic method so as to evaluate the conditions thereof and offer an expert advice to the customer; specifically, the battery will be tested together with the battery charger 200 initially associated therewith, so as to evaluate the overall performance thereof.

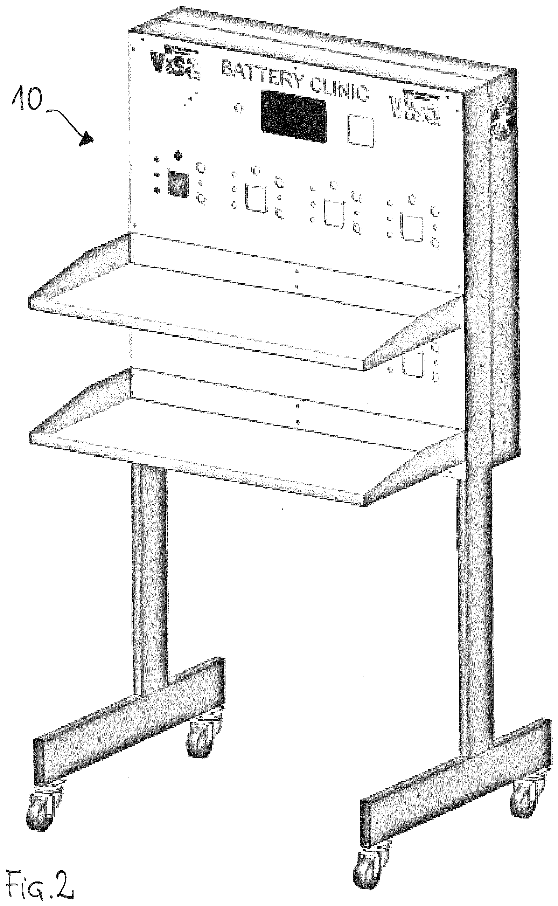

Advantageously, said diagnostic apparatus 1 comprises a support structure 10, for example shown in figure 2, provided with at least a support plane and provided with at least a station for a battery 100, and preferably a plurality of stations, therefore allowing to test several batteries 100 at the same time.

The apparatus 1 further comprises a command and control unit 40, to which the battery 100 to be tested may be connected with input/output connections including at least a processing unit (PLC) 41 and a temporary storage unit 50.

Detection means 30 are further provided for, said means arranged and configured to detect characteristic parameters of said battery 100 and transmit them to said command and control unit 40.

Preferably, said detection means 30 comprise a probe adapted to detect at least the voltage of the battery 100 and a current delivered/absorbed by the battery 100.

Furthermore, the command and control unit 40 can be operatively connected to at least an electrical load dissipation device 20 and to the battery charger 200, selectively couplable to said battery 100, to manage the operation thereof.

The battery charger 200 can be operatively connected to an electrical power source, such as power mains.

Advantageously, the command and control unit 40 is further operatively connected to a user interface 60, comprising a display screen, which can be obtained incorporated in or separately from the command and control unit 40, provided with an input terminal for entering data. Preferably, said user interface 60 is formed by a touch screen and access to control levels is allowed after the operator logs in with username and password.

Lastly, preferably, said apparatus 1 comprises a printing device 70, such as printer, adapted to print a document, such as some sort of "receipt", containing the results and/or the diagnosis of the diagnostic method conducted on the battery 100, and a storage unit 80 adapted to store the data acquired on the battery 100 and on the battery charger 200 associated therewith, both operatively connected to the command and control unit 40, during the diagnostic method.

Preferably, the command and control unit 40 is capable of communicating also in "wireless" mode with any device of the apparatus 1 or external entity operatively configured for wireless communication, further allowing to transfer - in input and in output - the data through communication networks such as the internet.

A diagnostic method for a battery 100 according to the present invention to be carried out at the time of sale thereof essentially comprising the following steps:
a) connecting at least a battery 100 to an apparatus 1 for battery diagnostics via input/output connections, said apparatus 1 including detection means 30 adapted to detect characteristic parameters of said battery 100, a command and control unit 40 comprising at least a temporary storage unit 50 configured to store the data associated with the battery and a processing unit PLC 41 for controlling the operation of at least an electrical load dissipation device 20 and of a battery charger 200 selectively couplable to said battery 100;
b) acquiring a series of nominal characteristic parameters SETn of the battery 100 and storing them in said temporary storage unit 50;
c) coupling said electrical load dissipation device 20 to said battery 100 and implementing a discharging cycle of said battery 100;
d) de-coupling said electrical load dissipation device 20 from said battery 100, coupling said battery charger 200 to said battery and implementing a charging cycle of said battery 100;
e) during said steps c) and d) detecting a series of current characteristic parameters SETr of the battery 100 through said detection means 30 and storing in the temporary storage unit 50;
f) comparing said series of nominal characteristic parameters SETn of the battery 100 with said series of current characteristic parameters SETr of the battery 100 to evaluate the compliance of the battery 100 with manufacture data.

Advantageously, in the step b) of acquiring the nominal characteristic parameters of the battery 100 it is also possible to indicate the tolerance factor, in absolute value, regarding which there can be deemed acceptable, that is essentially coincident, the detected characteristic parameter values with respect to the nominal values.

Should the values of the parameter series SETn and SETr of the battery 100 compared during step f) of the method be considered essentially coincident, then the compliance of the battery 100 can be certified.

On the other hand, should the values of the series of current characteristic parameters SETr of the battery 100 not be essentially coincident with the nominal values SETn, also considering the tolerance factor, the battery 100 cannot be certified as compliant. At this point, by examining the data detected during the test cycle, the operator may issue a diagnosis on the cause of non-compliance and, if necessary, provide for the disposal of the battery 100.

Step a) and step b) may possibly be inverted temporarily.

The step b) for acquiring nominal characteristic parameters SETn may be carried out manually by an operator, for example by entering - through said user interface 60 operatively connected to the command and control unit 40 - the manufacture data provided by the manufacturer of the battery, or extract the data, if available, from an appropriate database or from online libraries.

In particular, the characteristic parameters of a battery 100 are preferably at least the capacity C of the battery, measured in Amperes/hour (A/h), the cut-off voltage Tco and the end-of-charge voltage Tfc, both measured in Volts (V).

As a matter of fact, as explained above, a battery 100 comprises two or more cells connected in series or parallel, and it may be limited - in terms of power and/or capacity - by the "weakest" of such cells.

Therefore, during said step b) the series of nominal characteristic parameters SETn of the battery 100, that is at least the nominal capacity Cn, the cut-off voltage Tcon and the end-of-charge voltage Tfcn will be indicated.

Said detection means 30 are advantageously formed by a probe adapted to detect the voltage and current of the battery 100. The detecting of such parameters may be carried out continuously or, preferably, at intervals regular over time, for example every 5 seconds.

The discharging cycle according to step c) is interrupted upon reaching the cut-off voltage, and the value of the latter is therefore stored in the series of current characteristic parameters SETr as the detected cut-off voltage Tcor.

At this point, the full charging cycle of the battery 100 is started, as provided for in step d); the command and control unit 40 disconnects the load dissipator device 20 from the battery 100, connecting the battery charger 200 previously connected to the power mains.

The charging cycle according to step d) is interrupted upon reaching the end-of-charge voltage, and the value of the latter is therefore stored in the series of current characteristic parameters SETr as the detected end-of-charge voltage Tfcr.

During the charging cycle, the probe 30 detects the current absorbed by the battery 100, which allows to obtain the value of the current capacity Cr of the battery 100 once the time required to reach the end-of-charge voltage has been known; also this value is stored in the series of current characteristic parameters SETr.

The diagnostic method for a battery 100 according to the present invention, to be carried out instead after a determined period of time t from the purchase thereof, essentially comprising the following steps:
a) connecting at least a battery 100 to an apparatus 1 for battery diagnostics via input/output connections, said apparatus 1 including detection means 30 adapted to detect characteristic parameters of the battery 100, a command and control unit 40 comprising at least a temporary storage unit 50 configured to store the data associated with said battery and a processing unit PLC 41 for controlling the operation of at least an electrical load dissipation device 20 and of a battery charger 200 selectively couplable to said battery 100;
b) acquiring a series of nominal characteristic parameters SETn of the battery 100 and a series of scaled characteristic parameters SETt as a function of time t and storing them in said temporary storage unit 50;
c) coupling said electrical load dissipation device 20 to said battery 100 and implementing a discharging cycle of said battery 100;
d) de-coupling said electrical load dissipation device 20 from said battery 100, coupling said battery charger 200 to said battery and implementing a charging cycle of said battery 100;
e) during said steps c) and d) detecting a series of current characteristic parameters SETr of the battery 100 through said detection means 30 and storing in the temporary storage unit 50;
f) comparing said series of scaled characteristic parameters SETt of the battery 100 with said series of current characteristic parameters SETr of the battery 100 so as to evaluate the conditions of the battery 100 and of the battery charger 200 associated therewith so as to provide indications on the residual duration and use recommendations to the customer.

Advantageously, in step b) it is also possible to indicate the tolerance factor, in absolute value, regarding which there can be deemed acceptable, that is essentially coincident, the detected characteristic parameter values with respect to the scaled values.

Should the values of the series of parameters SETt and SETr of the battery 100 compared during step f) of the method be considered essentially coincident, then the compliance of the battery 100 can be certified at the standard deterioration process envisaged by the manufacturer.

Otherwise, should the values of the series of current characteristic parameters SETr of the battery 100 not be essentially coincident with the scaled values SETt, also considering the tolerance factor, the battery 100 cannot be certified as compliant. At this point, by examining the data detected during the test cycle, the operator may issue a diagnosis on the cause of non-compliance so as to provide the customer with useful indications and, if necessary, provide for the disposal of the battery 100.

The scaled characteristic parameters SETt as a function of time t are essentially parameters estimated based on the age of the battery, and they are generally provided by the manufacturer of the batteries.

Also in this case, steps a) and b) may be possibly inverted temporarily. Furthermore, the step b) for acquiring nominal characteristic parameters SETn and the scaled characteristic parameters SETt as a function of time t from purchase, may be carried out manually by an operator, for example by entering - through said user interface 60 operatively connected to the command and control unit 40 - the data provided by the manufacturer of the battery, or extract the data, if available, from an appropriate database or from online libraries.

Should the test refer to a battery 100 tested previously, the profile thereof can be extracted from the storage unit 80.

Said detection means 30 are advantageously formed by a probe adapted to detect the voltage and current of the battery 100. The detecting of such parameters may be carried out continuously or, preferably, at intervals regular over time, for example every 5 seconds.

The discharging cycle according to step c) is interrupted upon reaching the cut-off voltage, and the value of the latter is therefore stored in the series of current characteristic parameters SETr as the detected cut-off voltage Tcor.

At this point, the full charging cycle of the battery 100 according to step d) is started; the command and control unit 40 disconnects the load dissipator device 20 from the battery 100, connecting the battery charger 200 previously connected to the power mains.

The charging cycle according to step d) is interrupted upon reaching the end-of-charge voltage, and the value of the latter is therefore stored in the series of current characteristic parameters SETr as the detected end-of-charge voltage Tfcr.

During the charging cycle, the probe 30 detects the current absorbed by the battery 100, which allows to obtain the value of the current capacity Cr of the battery 100 once the time required to reach the end-of-charge voltage has been known; also this value is stored in the series of current characteristic parameters SETr.

In conclusion, a diagnostic method for a traction battery of the lithium type 100 for vehicles for mainly personal use, essentially comprising the following steps:
a) connecting at least a battery 100 equipped with a battery charger 200 associated with it, to an apparatus 1 for battery diagnostics via input/output connections, wherein said apparatus 1 includes at least detection means 30 adapted to detect characteristic parameters of said battery 100, a command and control unit 40 comprising at least a temporary storage unit 50 configured to store the data associated with said battery 100 and a processing unit 41 for controlling the operation of at least one electrical load dissipation device 20 and of said battery charger 200 connectable to an electrical power source, said electrical load dissipation device 20 and said battery charger 200 being selectively couplable to said battery 100;
b) acquiring a series of reference characteristic parameters (SETn, SETt) of the battery 100 and storing them in said temporary storage unit 50;
c) coupling said electrical load dissipation device 20 to said battery 100 and implementing a discharging cycle of said battery 100;
d) de-coupling said electrical load dissipation device 20 from said battery 100, coupling said battery charger 200 to said battery 100 and implementing a charging cycle of said battery 100;
e) detecting, during said steps c) and d), a series of current characteristic parameters (SETr) of said battery 100 through said detection means 30 and storing them in the temporary storage unit 50;
f) comparing said series of reference characteristic parameters (SETn, SETt) of the battery 100 with said series of current characteristic parameters (SETr) of the battery 100 to evaluate the compliance of the battery 100.

In the light of the above, it is clear that a diagnostic method for this reason according to the present invention allows to verify and possibly certify whether the battery actually complies with the characteristics stated by the manufacturer at the time of sale, as well as evaluate, after sale and at pre-established time intervals, the conditions of the battery, providing quality and quantity conditions relating to the residual duration of the battery.

Furthermore, the diagnostic method according to the present invention allows to verify even the conditions of the battery charger provided at the time of purchase together with the battery.

Lastly, it is clear that a diagnostic apparatus adapted to implement a diagnostic method according to the present invention is easy to assemble, given that it is formed by means and devices widely available on the market, and intuitive to use.

Obviously, the present invention is susceptible of numerous applications, modifications or variations without departing from the scope of protection, as defined in the attached claims.

Furthermore, the materials and equipment used in the present invention, as well as the shapes and dimensions of the individual components, may be the most appropriate depending on the specific requirements.

## Claims

1. Diagnostic method for traction batteries of the lithium type (100) for vehicles for mainly personal use, said method essentially comprising the following steps:
a) connecting at least one battery (100) equipped with a battery charger (200) associated with it, to an apparatus (1) for battery diagnostics via input/output connections, said apparatus (1) including at least detection means (30) adapted to detect characteristic parameters of said battery (100), a command and control unit (40) comprising at least a temporary storage unit (50) configured to store the data associated with said battery (100) and a processing unit (41) for controlling the operation of at least one electrical load dissipation device (20) and of said battery charger (200) connectable to an electrical power source, said electrical load dissipation device (20) and said battery charger (200) being selectively couplable to said battery (100);
b) acquiring a series of reference characteristic parameters (SETn, SETt) of the battery (100) and storing them in said temporary storage unit (50);
c) coupling said electrical load dissipation device (20) to said battery (100) and implementing a discharging cycle of said at least a battery (100);
d) de-coupling said electrical load dissipation device (20) from said battery (100), coupling said battery charger (200) to said battery (100) and implementing a charging cycle of said battery (100);
e) detecting, during said steps c) and d), a series of current characteristic parameters (SETr) of said battery (100) through said detection means (30) and storing them in the temporary storage unit (50);
f) comparing said series of reference characteristic parameters (SETn, SETt) of the battery (100) with said series of current characteristic parameters (SETr) of the battery (100) to evaluate the compliance of the battery (100).

2. Diagnostic method according to claim 1, wherein said reference characteristic parameters (SETn, SETt) and said current characteristic parameters (SETr) comprise at least the capacity (C) of said battery (100), a cut-off voltage (Tco) of said battery (100) and an end-of-charge voltage (Tfc) of said battery (100).

3. Diagnostic method according to claim 1 or 2, wherein in said step b) a tolerance factor is also indicated, in absolute value, for which in said step f) the values of said current characteristic parameters (SETr) are considered essentially coincident with said reference characteristic parameters (SETn, SETt).

4. Diagnostic method according to any one of claims 1 to 3, to be carried out upon sale of said battery (100), wherein in said step b) a series of nominal characteristic parameters (SETn) of said battery (100) is acquired.

5. Diagnostic method according to any one of claims 1 to 3, to be carried out after a determined period of time (t) from the purchase of said battery (100), wherein in said step b) a series of scaled characteristic parameters scaled as a function of time (SETt) of said battery (100) is acquired.

6. Apparatus (1) for the diagnosis of at least a battery adapted to implement a diagnostic method for a traction battery of the lithium type for vehicles for mainly personal use according to any one of claims 1 to 5, comprising detection means (30) adapted to detect characteristic parameters of said battery (100), a command and control unit (40) comprising at least a temporary storage unit (50) configured to store the data associated with said battery (100), an electrical load dissipation device (20) and a processing unit (41).

7. Apparatus (1) according to claim 6, wherein said detection means (30) comprise a probe adapted to detect at least the voltage of said battery (100) and a current delivered / absorbed by said battery (100).

8. Apparatus (1) according to claim 6 or 7, further comprising a printing device (70) adapted to print a document containing the results and/or the diagnosis of the diagnostic method carried out on said battery (100).

9. Apparatus (1) according to any one of claims 6 to 8 comprising a support structure (10) equipped with at least one support surface and provided with at least one station for testing a battery (100).

10. Apparatus (1) according to any one of claims 6 to 9, wherein said command and control unit (40) is operatively connected to a user interface (60) comprising a display screen and an input terminal for entering data.
